Europäisches Patentamt

European Patent Office

Office européen des brevets

(19)

(11) Veröffentlichungsnummer: **0 177 675**
**A2**

(12) # EUROPÄISCHE PATENTANMELDUNG

(21) Anmeldenummer: 85107937.6

(22) Anmeldetag: 26.06.85

(51) Int. Cl.⁴: **H 03 H 7/48**

(30) Priorität: **22.09.84 DE 3434891**

(43) Veröffentlichungstag der Anmeldung: **16.04.86**
**Patentblatt 86/16**

(84) Benannte Vertragsstaaten: **AT CH DE FR GB IT LI NL SE**

(71) Anmelder: **ROBERT BOSCH GMBH, Postfach 50,**
**D-7000 Stuttgart 1 (DE)**

(72) Erfinder: **Pfizenmaier, Heinz, Dipl.-Ing., Liststrasse 6,**
**D-7250 Leonberg (DE)**
Erfinder: **Schmidt, Ewald, Ing. grad., Bachstrasse 10,**
**D-7140 Ludwigsburg (DE)**

(74) Vertreter: **Schmidt, Hans-Ekhardt, Robert Bosch GmbH**
**Geschäftsbereich Elektronik Patent- und**
**Lizenzabteilung Forckenbeckstrasse 9-13,**
**D-1000 Berlin 33 (DE)**

(54) **HF-Breitbandübertragerschaltung.**

(57) Es wird eine HF-Breitbandübertragerschaltung vorgeschlagen, die gute elektrische Eigenschaften im Fernsehfrequenzbereich und im LMKU-Frequenzbereich aufweist. Die
Schaltung geht von einem Breitbandübertrager mit Doppellochkern (K) aus, der vier Wicklungen (W1...W4) trägt. Wesentlich für die Erfindung ist, daß der zweite Ausgang (S)
der Übertragerschaltung über die erste Wicklung (W1) und
einen dazu in Reihe liegenden zweiten Widerstand (R2) und
der Eingang (E) über die vierte Wicklung (W4) und einen
dazu in Reihe liegenden dritten Widerstand (R3) mit dem
Massepotential verbunden ist.

EP 0 177 675 A2

29/84
EK/PLI Schmidt-Li
20.9.1984


ROBERT BOSCH GMBH, 7000 Stuttgart 1


HF-Breitbandübertragerschaltung


## Stand der Technik

Die Erfindung geht von einer HF-Breitbandübertragerschaltung nach der Gattung des Anspruchs 1 aus.

Es ist schon eine HF-Breitbandübertragerschaltung bekannt (DE-AS 24 48 737), bei der ein Doppellochkern vier Wicklungen trägt, die auf folgende Weise mit einem Eingang der Schaltung, einem ersten Ausgang, einem zweiten Ausgang (Stich) und Masse verbunden sind. Der zweite Ausgang steht über eine erste Wicklung und eine dazu gleichstrommäßig in Reihe liegende vierte Wicklung mit dem Eingang in Verbindung. Ein Anschluß zwischen der ersten und vierten Wicklung ist über einen kapazitiv überbrückten ersten Widerstand mit Masse verbunden. Den Eingang und den ersten Ausgang verbindet eine zweite Wicklung, und der zweite Ausgang steht außerdem über eine dritte Wicklung und einen dazu in Reihe liegenden zweiten Widerstand mit Masse in Verbindung. Die bekannte Übertragerschaltung liefert eine annähernd konstante Ausgangsspannung über den gesamten zu übertragenden Frequenzbereich von 40 ... 800 MHz bei verhältnismäßig hohem Dämpfungswert zwischen erstem und zweitem Ausgang. Für Frequenzen unter 40 MHz ist die bekannte Übertragerschaltung weniger geeignet.

...

## Vorteile der Erfindung

Die erfindungsgemäße HF-Breitbandübertragerschaltung mit den kennzeichnenden Merkmalen des Anspruchs 1 hat den Vorteil, daß sich alle
für die Übertragung der Hochfrequenzspannung maßgebenden Dämpfungswerte, die Durchgangsdämpfung zwischen Eingang und erstem Ausgang,
die Anschlußdämpfung zwischen Eingang und zweitem Ausgang und die
Entkopplungsdämpfung zwischen erstem und zweitem Ausgang, insbesondere im unteren Frequenzbereich verbessern. Ein weiterer Vorteil der
erfindungsgemäßen Schaltung besteht darin, daß, falls bei einer Übertragerschaltung aus bestimmten Gründen die untere Grenzfrequenz nicht
verringert zu werden braucht, die Abmessungen des zu verwendenden
Übertragers kleiner gewählt werden können. Ein weiterer Vorteil besteht
darin, daß sich die Reflexion am Eingang, am ersten Ausgang und zweiten
Ausgang verbessert.

Durch die in den Unteransprüchen aufgeführten Maßnahmen sind vorteilhafte Weiterbildungen und Verbesserungen der im Anspruch 1 angegebenen
HF-Breitbandübertragerschaltung möglich. Besonders vorteilhaft ist ein
erfindungsgemäßer Übertrager, bei dem unter bestimmten Umständen auf
den zweiten oder den dritten Widerstand verzichtet werden kann, wodurch
sich der Aufbau der Übertragerschaltung vereinfacht.

## Zeichnung

Zwei Ausführungsbeispiele der Erfindung werden in der Zeichnung an Hand
mehrerer Figuren dargestellt und in der nachfolgenden Beschreibung näher
erläutert. Die Zeichnung zeigt in

Fig. 1  eine erfindungsgemäße Übertragerschaltung mit
        drahtgewickeltem Übertrager,
Fig. 2  eine Schaltungsvariante zu Fig. 1,
Fig. 3  ein Schaltbild einer Übertragerschaltung für
        die Planartechnik und
Fig. 4  ein Layout für eine Übertragerschaltung gemäß
        Fig. 3.

...

Beschreibung der Erfindung

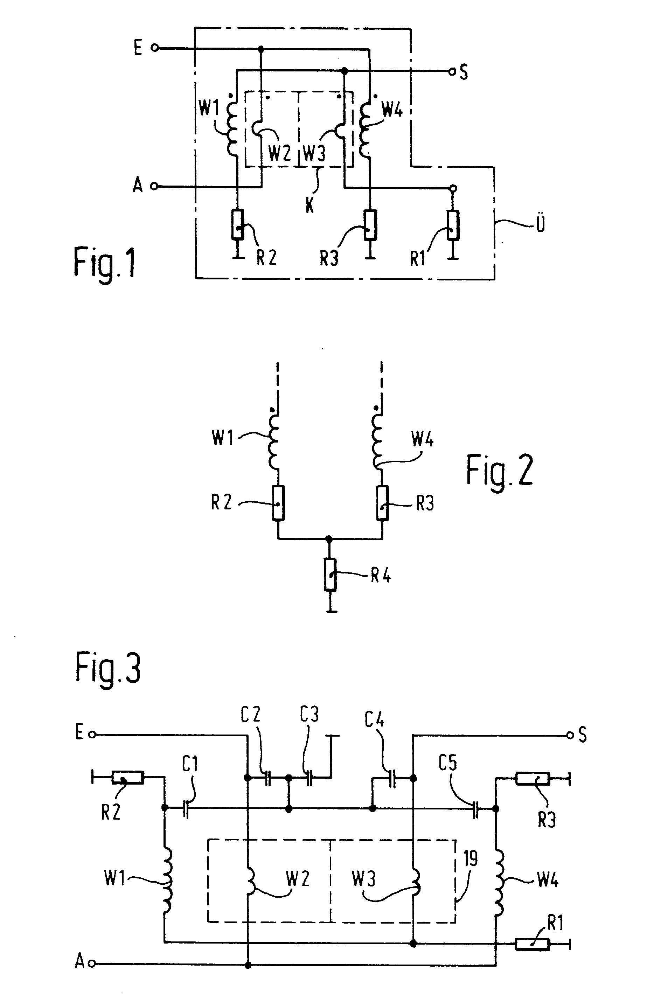

Eine in Fig. 1 gezeigte erfindungsgemäße HF-Breitbandübertragerschaltung Ü weist einen Eingang E, einen ersten Ausgang A und einen
zweiten Ausgang S (Stich) auf. Die Übertragerschaltung umfaßt einen
Doppellochkern K, dessen eine Kernhälfte eine erste und zweite Wicklung W1, W2 und dessen zweite Kernhälfte eine dritte und vierte Wicklung W3, W4 trägt. Die erste Wicklung W1 liegt zwischen dem zweiten
Ausgang S und einem mit Masse verbundenen zweiten Widerstand R2, die
zweite Wicklung W2 zwischen dem Eingang E und dem ersten Ausgang A,
die dritte Wicklung W3 zwischen dem zweiten Ausgang S und einem ersten
Widerstand R1 und die vierte Wicklung W4 zwischen dem Eingang E und
einem dritten mit Masse verbundenen Widerstand R3.

Die Wirkungsweise der vorstehend beschriebenen Übertragerschaltung ist
folgende.

Durch die Wahl der Widerstandswerte für die Widerstände R1, R2 und R3
können die elektrischen Eigenschaften der Übertragerschaltung innerhalb
bestimmter Grenzen variiert werden, um eine für den jeweiligen Anwendungszweck geeignete Übertragerschaltung zu erhalten. Die Übertragerschaltung findet beispielsweise als Abzweiger in Fernseh-Gemeinschaftsantennenanlagen Anwendung. Sie muß dort neben den Fernsehfrequenzen
zwischen 40 ... 860 MHz auch Signale des LMKU-Frequenzbereiches übertragen. Der Wert des Widerstandes R1 richtet sich nach dem Wellenwiderstand der anzuschließenden Leitung, das ist in der Regel ein Koaxialkabel, und nach dem Übertragertyp. Entscheidend für die Wahl der Widerstandswerte für die Widerstände R2 und R3 ist der Übertragertyp. Bei
einem 10-dB-Typ und bei einem 12-dB-Typ kann - wie Messungen ergeben
haben - der Widerstandswert für den Widerstand R2 = 0 $\Omega$ und für den
Widerstand R3 ungefähr = 8 ... 11 $\Omega$ betragen. Während der untere Wert
für eine optimale Anpassung maßgebend ist, führt der obere Widerstandswert zu einer optimalen Entkopplung. Dem Fachmann bleibt es nun überlassen, je nach den gewünschten Eigenschaften der Übertragerschaltung
einen Kompromiß zu schließen.

...

Bei einem 15-dB-Typ kann - wie Messungen ergeben haben - entweder der
zweite Widerstand R2 oder der dritte Widerstand R3 entfallen. Im ersten
Fall (R2 = 0 $\Omega$) erhält man eine höhere Entkopplung bei Übertragungsfrequenzen über 1 MHz bei optimaler Reflexion am ersten Ausgang. Im zweiten
Fall (R3 = 0 $\Omega$) ergeben sich bessere Entkopplungswerte bei Frequenzen
über 500 MHz und bei etwa 150 kHz.

Als vorteilhaft hat sich auch eine Übertragerschaltung nach Fig. 2 erwiesen, bei der die Widerstände R2, R3 nicht unmittelbar, sondern über
einen gemeinsamen Widerstand R4 mit Masse in Verbindung stehen. Mit einer
derartigen Übertragerschaltung kann bei geeigneter Wahl der Widerstandswerte für die Widerstände R2, R3, R4 in einem Frequenzbereich von etwa
5 ... 860 MHz ein annähernd konstanter Wert der Entkopplung erreicht werden.

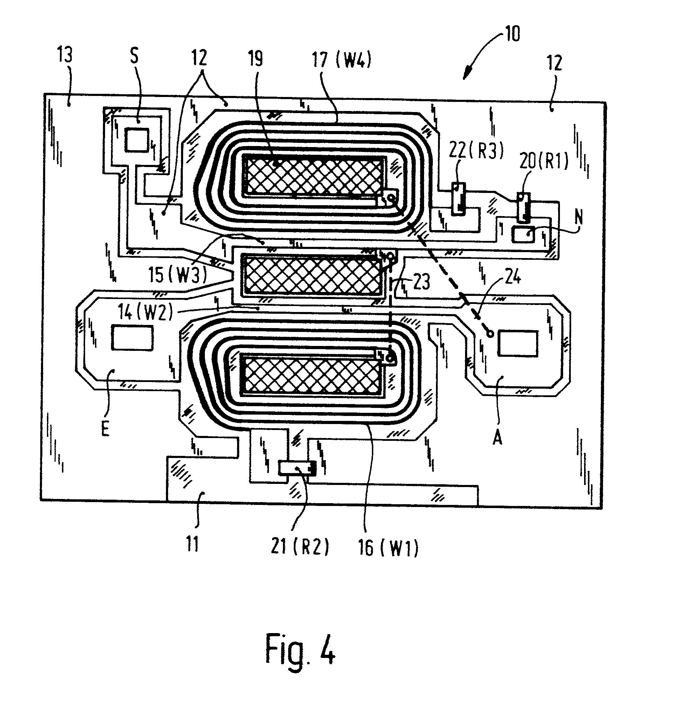

Die in Fig. 4 lediglich als ein mögliches Layout gezeigte Leiterplatte 10
stellt eine Übertragung des Schaltungsprinzips nach Fig. 3 auf eine in
Planartechnik herzustellende Schaltung dar. Auf einer ebenen Platte 11 aus
dielektrischem Material sind die erforderlichen Leitungsverbindungen durch
Leitungsbahnen 12 und Leitungsflächen 13, die Wicklungen W2 und W3 durch
gerade Leitungsbahnen 14, 15 und die Wicklungen W1 und W4 durch spiralförmig
angeordnete Leitungsbahnen 16, 17 realisiert. Der Doppellochkern ist in den
Fig. 3 und 4 mit 19 bezeichnet und durchsetzt drei Öffnungen der Platte 11.
Die in Fig. 3 mit C1 bis C5 bezeichneten Kondensatoren werden in der Planartechnik dadurch realisiert, daß ein zweites dielektrisches Substrat über
Teile des dargestellten Layouts aufgebracht wird, wobei die Rückseite dieses
zweiten Substrates eine Leiterfläche aufweist, die sonst nicht kontaktiert
ist. Damit werden in Reihe geschaltete Kapazitäten C1 ...C5 erzeugt.

Die Widerstände R1 bis R3 sind in Fig. 4 mit 20, 21 und 22 bezeichnet
und vorzugsweise als Chip-Widerstände ausgebildet.

Die Verbindungen zwischen den Wicklungen W1 und W3 bzw. W2 und W4
sind in Fig. 4 durch gestrichelte Linien 23 und 24 dargestellt, da sie
durch entsprechende Leiterbahnen auf der Rückseite der Leiterplatte 10
realisiert sind.

29/84
EK/PLI Scht-Li
20.9.1984

— 1 —

ROBERT BOSCH GMBH, 7000 Stuttgart 1

Ansprüche

1. HF-Breitbandübertragerschaltung mit einem Eingang, einem ersten Ausgang und einem zweiten Ausgang (Stich) sowie mit einem Doppellochkern, dessen erste Kernhälfte eine erste und zweite Wicklung und dessen zweite Kernhälfte eine dritte und vierte Wicklung trägt, wobei der Eingang über die zweite Wicklung mit dem ersten Ausgang und der zweite Ausgang über die dritte Wicklung mit einem dazu in Reihe liegenden ersten Widerstand mit dem Massepotential verbunden sind, dadurch gekennzeichnet, daß der zweite Ausgang (S) über die erste Wicklung (W1) und einen dazu in Reihe liegenden zweiten Widerstand (R2) und der Eingang (E) über die vierte Wicklung (W4) und einen dazu in Reihe liegenden dritten Widerstand (R3) mit dem Massepotential verbunden sind.

2. HF-Breitbandübertragerschaltung nach Anspruch 1 mit planarem Aufbau, dadurch gekennzeichnet, daß der erste Ausgang (A) über die vierte Wicklung (W4) und einen damit in Reihe liegenden dritten Widerstand (R3) mit dem Massepotential und ein Abgriff zwischen der dritten Wicklung (W3) und dem dazu in Reihe liegenden ersten Widerstand (R1) über die erste Wicklung (W1) und einen damit in Reihe liegenden zweiten Widerstand (R2) mit dem Massepotential verbunden sind und daß zwischen dem Eingang (E) und dem ersten Ausgang (A) die zweite Wicklung (W2) vorgesehen ist.

3. HF-Breitbandübertragerschaltung nach Anspruch 1 oder 2, dadurch gekennzeichnet, daß der zweite oder der dritte Widerstand (R2, R3) den Widerstandswert 0 $\Omega$ aufweist.

0177675

**Fig.1**

**Fig.2**

**Fig.3**

0177675 29/84

Fig. 4